# EUROPEAN PATENT APPLICATION

(11) **EP 4 586 410 A1**
(43) Date of publication of application: **16.07.2025**
(21) Application number: 24217195.7
(22) Date of filing: 03.12.2024
(51) Int. Cl.: H01R 12/58, H01R 13/432

(54) **ELECTRICAL TERMINAL FOR AN ELECTRONIC DEVICE**

(30) Priority: 12.01.2024 IN 202411002455
(71) Applicant: Honeywell International Inc., Charlotte, NC 28202 (US)
(72) Inventor: RAO, Sharath N, Charlotte, 28202 (US); M, Jithun, Charlotte, 28202 (US); B R, Gangaraju, Charlotte, 28202 (US)
(74) Representative: Haseltine Lake Kempner LLP

(57) **Abstract**

An electrical terminal includes a main body that extends along a plane. The electrical terminal includes at least one shoulder extending away from the main body. The electrical terminal includes a flag snap positioned downward from the at least one shoulder. The electrical terminal can be installed within an electronic device. The electronic device includes a housing and a circuit board positioned within the housing.

## Description

### TECHNICAL FIELD

The present application relates generally electrical terminals. More specifically, the present application relates to electrical terminals for electronic devices.

### BACKGROUND

Electronic devices often include electrical terminals. For example, an electrical terminal may be provided to transmit electrical current and/or electrical signals to a circuit board of an electronic device from an electrical current and/or electrical signal source.

The inventor has identified numerous deficiencies and problems with the existing technologies in this field. Through applied effort, ingenuity, and innovation, many of these identified deficiencies and problems have been solved by developing solutions that are structured in accordance with the embodiments of the present disclosure, many examples of which are described in detail herein.

### BRIEF SUMMARY

In general, embodiments of the present disclosure provided herein include systems, methods, and apparatuses to provide for improved electrical terminals for electronic devices.

In various aspects, an electronic device includes a housing, a circuit board positioned within the housing, and at least one electrical terminal positioned at least partially within the circuit board. Each electrical terminal may include a main body that extends along a plane, at least one shoulder extending away from the main body, and a flag snap positioned downward from the at least one shoulder and within the housing.

In various examples, the flag snap of each electrical terminal is configured to pivot relative to the main body.

In various examples, the flag snap of each electrical terminal is configured to pivot from a first position to a second position relative to the main body. When the flag snap is in the first position, the flag snap may be positioned on the plane. When the flag snap is in the second position, the flag snap may extend away from the plane.

In various examples, when the flag snap of each electrical terminal is in the second position, the flag snap extends away from the plane and in an upward direction.

In various examples, the flag snap of each electrical terminal is configured to pivot from the second position to the first position such that the electrical terminal may be uninstalled from the electronic device.

In various examples, the flag snap of each electrical terminal is configured to pivot relative to the main body from a first position to a second position. When the flag snap is in the first position, the flag snap may be allowed to move upward relative to the housing. When the flag snap is in the second position, the flag snap may be prevented from moving upward relative to the housing.

In various examples, when the flag snap of each electrical terminal is in the second position, the flag snap may be positioned on an overhang of the housing.

In various examples, each of the at least one shoulder of each electrical terminal is positioned on a respective plane defined by a respective main body of the respective electrical terminal.

In various examples, each of the at least one shoulder of each electrical terminal defines a surface that extends in a transverse direction.

In various examples, the at least one shoulder of each electrical terminal is positioned on a respective seat of the housing.

In various examples, each electrical terminal comprises an electrical contact extending downward from the main body.

In various examples, the electrical contact of each electrical terminal is compressed within a respective orifice of the circuit board.

In various examples, the electrical contact of each electrical terminal is positioned on a plane defined by a respective main body of the respective electrical terminal.

In various examples, the electrical contact defines a hollow oval shape.

In various aspects, an electrical terminal includes a main body that extends along a plane, at least one shoulder extending away from the main body, and a flag snap positioned downward from the at least one shoulder.

In various examples, the flag snap of the electrical terminal is configured to pivot from a first position to a second position relative to the main body. When the flag snap is in the first position, the flag snap may be positioned on the plane. When the flag snap is in the second position, the flag snap may extend away from the plane.

In various examples, when the flag snap of the electrical terminal is in the second position, the flag snap extends away from the plane and in an upward direction.

In various examples, the at least one shoulder of the electrical terminal is positioned on the plane defined by the main body of the electrical terminal. The at least one shoulder of the electrical terminal may define a surface that extends in a transverse direction.

In various examples, the electrical terminal comprises an electrical contact extending downward from the main body. The electrical contact may be positioned on the plane.

In various examples, the electrical contact defines a hollow oval shape.

The above summary is provided merely for purposes of summarizing some example embodiments to provide a basic understanding of some aspects of the present disclosure. Accordingly, it will be appreciated that the above-described embodiments are merely examples and should not be construed to narrow the scope or spirit of the present disclosure in any way. It will be appreciated that the scope of the present disclosure encompasses many potential embodiments in addition to those here summarized, some of which will be further described below. Other features, aspects, and advantages of the subject matter will become apparent from the description, the drawings, and the claims.

### BRIEF DESCRIPTION OF THE DRAWINGS

Having thus described certain example embodiments of the present disclosure in general terms above, non-limiting and non-exhaustive embodiments of the subject disclosure are described with reference to the following figures, which are not necessarily drawn to scale and wherein like reference numerals refer to like parts throughout the various views unless otherwise specified. The components illustrated in the figures may or may not be present in certain embodiments described herein. Some embodiments may include fewer (or more) components than those shown in the figures.
FIG. 1A provides a front view of an electrical terminal, in accordance with an example embodiment.
FIG. 1B provides a side view of the electrical terminal of FIG. 1A, in accordance with an example embodiment.
FIG. 2A provides a perspective view of the electrical terminal of FIG. 1A, in accordance with an example embodiment.
FIG. 2B provides a partial perspective view of the electrical terminal of FIG. 1A, in accordance with an example embodiment.
FIG. 3 provides a perspective view of an electronic device, in accordance with an example embodiment.
FIG. 4 provides a cross-sectional view of a portion of the electronic device of FIG. 3, in accordance with an example embodiment.
FIG. 5 provides a cross-sectional view of a portion of the electronic device of FIG. 3, in accordance with an example embodiment.
FIG. 6 provides a cross-sectional view of a portion of the electronic device of FIG. 3, in accordance with an example embodiment.
FIG. 7 provides a cross-sectional view of a portion of the electronic device of FIG. 3, in accordance with an example embodiment.

### DETAILED DESCRIPTION

One or more embodiments are now more fully described with reference to the accompanying drawings, wherein like reference numerals are used to refer to like elements throughout and in which some, but not all embodiments of the inventions are shown. In the following description, for purposes of explanation, numerous specific details are set forth in order to provide a thorough understanding of the various embodiments. It is evident, however, that the various embodiments can be practiced without these specific details. It should be understood that some, but not all embodiments are shown and described herein. Indeed, the embodiments may be embodied in many different forms, and accordingly this disclosure should not be construed as limited to the embodiments set forth herein. Rather, these embodiments are provided so that this disclosure will satisfy applicable legal requirements.

As used herein, the term "exemplary" means serving as an example, instance, or illustration. Any aspect or design described herein as "exemplary" is not necessarily to be construed as preferred or advantageous over other aspects or designs. Rather, use of the word exemplary is intended to present concepts in a concrete fashion. In addition, while a particular feature may be disclosed with respect to only one of several implementations, such feature may be combined with one or more other features of the other implementations as may be desired and advantageous for any given or particular application. Furthermore, to the extent that the terms "includes" and "including" and variants thereof are used in either the detailed description or the claims, these terms are intended to be inclusive in a manner similar to the term "comprising."

As used herein, the term "or" is intended to mean an inclusive "or" rather than an exclusive "or". That is, unless specified otherwise, or clear from context, "X employs A or B" is intended to mean any of the natural inclusive permutations. That is, if X employs A; X employs B; or X employs both A and B, then "X employs A or B" is satisfied under any of the foregoing instances. In addition, the articles "a" and "an" as used in this application and the appended claims should generally be construed to mean "one or more" unless specified otherwise or clear from context to be directed to a singular form.

As used herein, the term "electrical communication" means that an electric current and/or an electric signal are capable of making the connection between the areas specified.

As used herein, the terms "coupled," "fixed," "attached to," and the like refer to both direct coupling, fixing, or attaching, as well as indirect coupling, fixing, or attaching through one or more intermediate components or features, unless otherwise specified herein.

As used herein, the term "positioned directly on" refers to a first component being positioned on a second component such that they make contact 440. Similarly, as used herein, the term "positioned directly between" refers to a first component being positioned between a second component and a third component such that the first component makes contact 440 with both the second component and the third component. In contrast, a first component that is "positioned between" a second component and a third component may or may not have contact 440 with the second component and the third component. Additionally, a first component that is "positioned between" a second component and a third component is positioned such that there may be other intervening components between the second component and the third component other than the first component.

As used herein, terms of approximation, such as "approximately," "substantially," or "about," refer to being within manufacturing or engineering tolerances. For example, terms of approximation may refer to being within a five percent margin of error.

### Exemplary Electrical Terminals

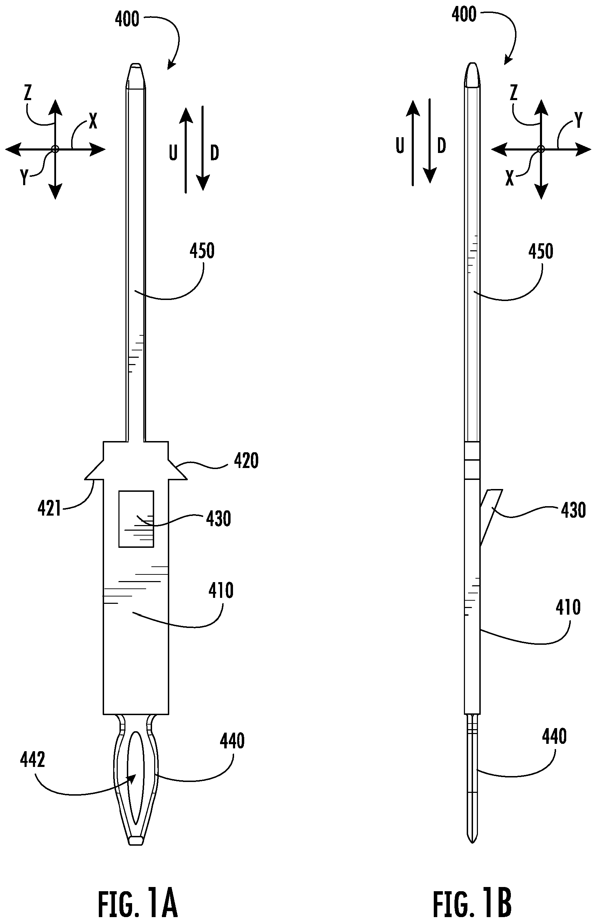

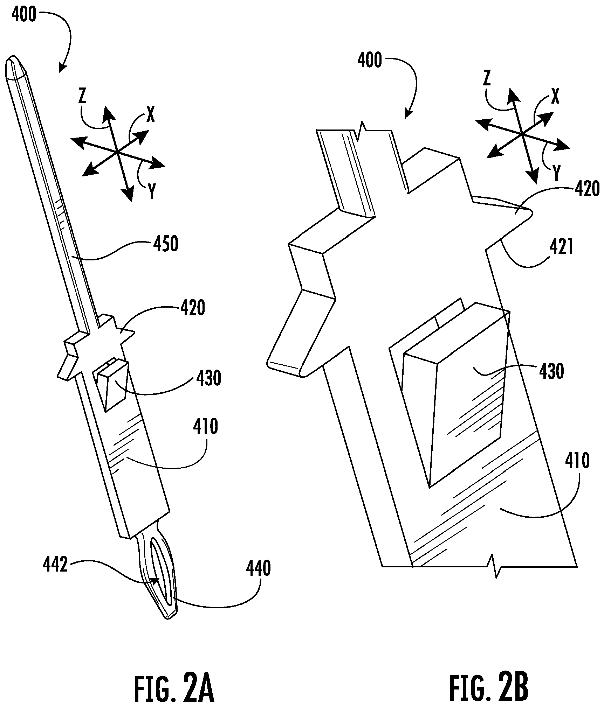

Referring now to FIGS. 1A-2B, various views of an electrical terminal 400 are provided, in accordance with an example embodiment. FIG. 1A provides a front view, FIG. 1B provides a side view, FIG. 2A provides a perspective view, and FIG. 2B provides a partial perspective view of the electrical terminal 400, in accordance with an example embodiment.

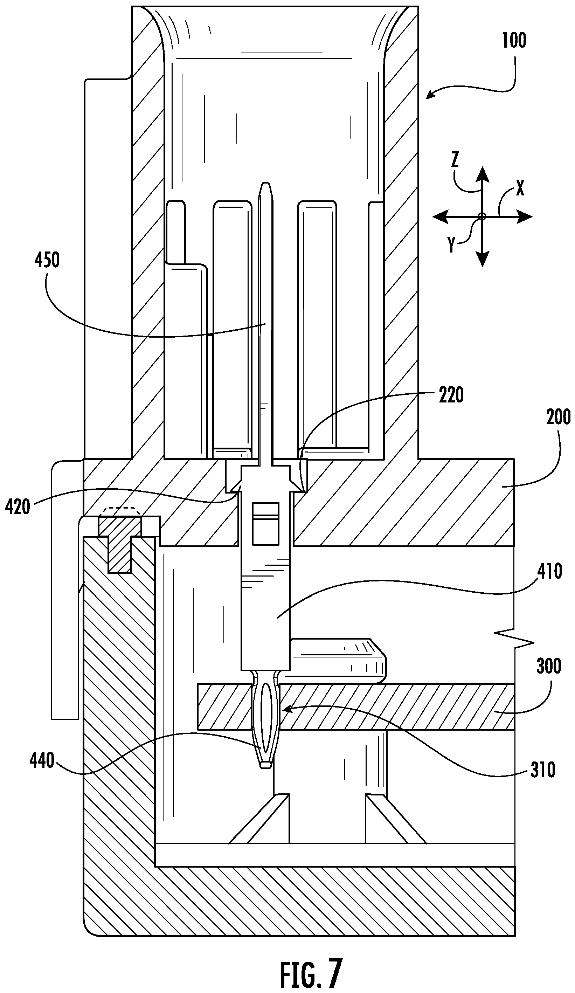

The electrical terminal 400 may define an X direction, a Y direction that is orthogonal to the X direction, and a Z direction that is orthogonal to the X direction and the Y direction. The Z direction may be a longitudinal direction and the X direction may be a transverse direction. The electrical terminal 400 may define an upward direction U and a downward direction D that extend in opposite direction in the Z direction. The electrical terminal 400 may comprise of an electrically conductive material such as copper, gold, silver, platinum, or a combination thereof. As will be discussed further, the electrical contact 440 may be configured to be in electrical communication with a circuit board 300 (FIG. 7), such as a printed circuit board assembly (PCBA).

The electrical terminal 400 may include a main body 410 that extends along an XZ plane defined by the X direction and the Z direction. The main body 410 may have any cross-sectional shape. For example, and as depicted, the main body 410 may have a cross-sectional rectangular shape. The main body 410 may have a consistent thickness (i.e., thickness extending in the Y direction), as depicted. In various examples, the main body 410 has an inconsistent thickness. The main body 410 may have a height that extends in the Z direction that is greater than a width that extends in the X direction such that the main body 410 is elongated.

The electrical terminal 400 may include a shank 450. The shank 450 may be elongated and may extend upward from the main body 410 in the Z direction. In various examples, and as depicted, the shank 450 may have a pointed distal end. The shank 450 may be configured to be in electrical communication with an electrical current and/or signal source (not depicted).

The electrical terminal 400 may include at least one shoulder 420, such as at least two shoulders 420, that each extend away from the main body 410. For example, and as depicted, each shoulder 420 may be positioned on the XZ plane and may extend away from the main body 410 in the X direction. Each shoulder 420 may have any cross-sectional shape. For example, and as depicted, each shoulder 420 may have a cross-sectional triangular shape, such as a cross-sectional right triangular shape. In various examples, the shoulder 420 includes a surface 421 that extends along an XY plane defined by the X direction and the Y direction.

The electrical terminal 400 may include at least one flag snap 430, such as at least two flag snaps 430, positioned downward from the at least one shoulder 420. Each flag snap 430 may have any cross-sectional shape. For example, each flag snap 430 may have a rectangular cross-sectional shape, as depicted.

Each flag snap 430 may be configured to pivot relative to the main body 410. For example, the flag snap 430 may be configured to pivot from a first position to a second position, and vice-versa. When the flag snap 430 is in the first position, the flag snap 430 may be positioned on (e.g., positioned completely on and extending on) the XZ plane. When the flag snap 430 is in the second position, as depicted, the flag snap 430 may extend away from the XZ plane. For example, when the flag snap 430 is in the second position, the flag snap 430 may extend away from the XZ plane and in an upward direction.

In various examples, the flag snap 430 is manufactured by cutting portions of the flag snap 430 from the main body 410 of the electrical terminal 400. Any cutting manufacturing process may be used, such as laser cutting. When the flag snap 430 has a rectangular shape, all sides except for a bottom side may be cut from main body 410 of the electrical terminal 400. The electrically conductive material that the electrical terminal 400 is manufactured from (e.g., copper, gold, silver, platinum, or a combination thereof) may be pliable. As such, the flag snap 430 may be able to be bent (i.e., pivot) to the second position.

The electrical terminal 400 may include a contact 440 extending downward from the main body 410. The contact 440 may be positioned and extend on the XZ plane. The contact 440 may define a cross-sectional, hollow oval shape. For example, the contact 440 may define an eye 442, which may be an orifice 310 that extends in the Y direction and is defined within the contact 440. The contact 440 may have a pointed distal end.

In various examples, the shank 450 is in electrical communication with the contact 440. For example, the main body 410, the shoulder 420, the flag snap 430, the contact 440, and the shank 450 of the electrical terminal 400 are in electrical communication with each other. In various examples, the main body 410, the shoulder 420, the flag snap 430, the contact 440, and the shank 450 of the electrical terminal 400 may comprise of the same one or more materials and may be monolithic.

### Exemplary Electronic Devices

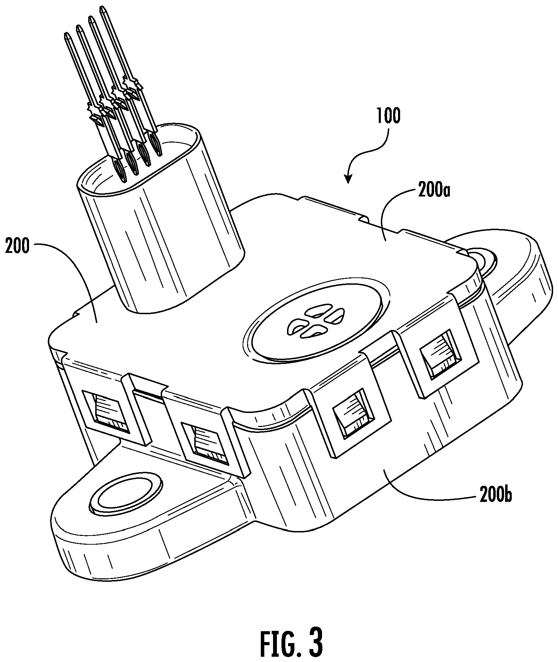

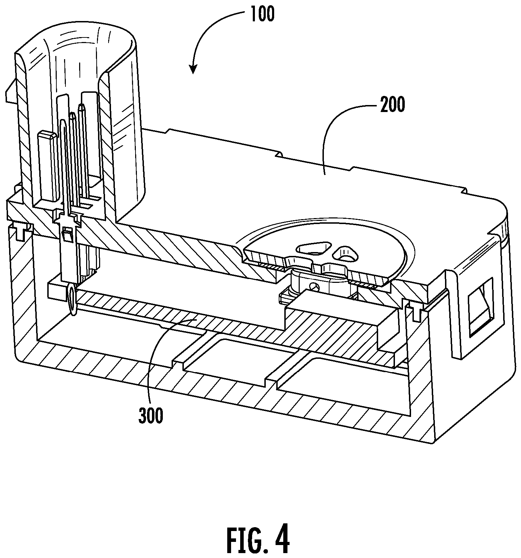

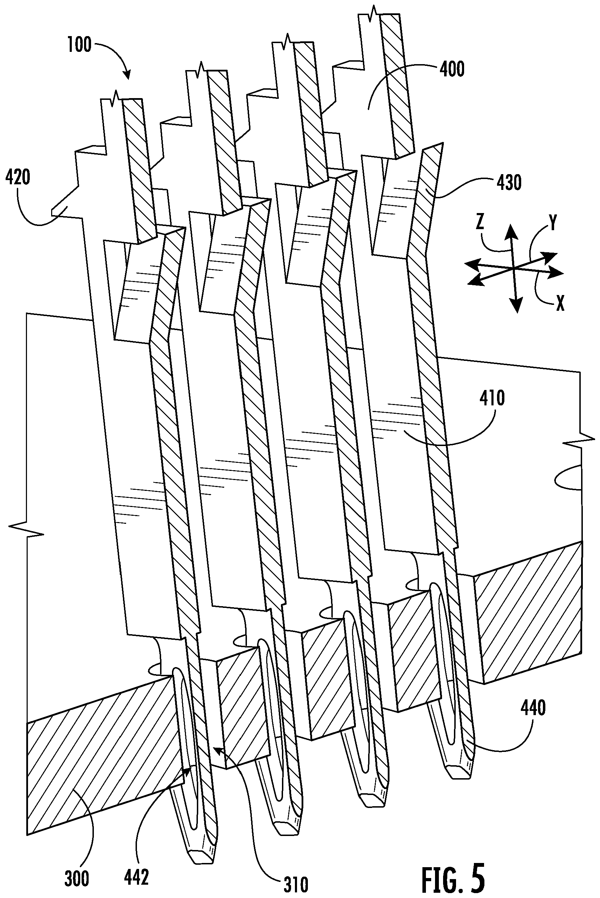

Referring now to FIGS. 3-7, various views of various portions of an electronic device 100 are provided, in accordance with an example embodiment. FIG. 3 provides a perspective view of the electronic device 100, and FIGS. 4-7 provide cross-sectional perspective views of portions of the electronic device 100, in accordance with an example embodiment.

The electronic device 100 may be configured as any device that may require an electrical connection via an electrical contact, such as electrical contact 440. For example, the electronic device 100 may be a sensor, such as a gas sensor.

The electronic device 100 may include a housing 200 and a circuit board 300, such as a printed circuit board assembly (PCBA), that is positioned within the housing 200. The housing 200 may be monolithic or the housing 200 may include separate portions that are coupled together. For example, the housing 200 may include an upper housing 200a and a lower housing 200b that are coupled together.

At least one electrical terminal 400 may be positioned at least partially within the housing 200. For example, a plurality of electrical terminals 400, such as at least four or more, such as at least six ore more electrical terminals 400 may each be positioned at least partially within the housing 200.

In various examples, the contact 440 of each electrical terminal 400 may be positioned within the housing 200. For example, the contact 440 of each electrical terminal 400 may be positioned within a respective orifice 310 of the circuit board 300. With reference to FIG. 7, the contact 440 of each electrical terminal 400 may be compressed within the respective orifice 310 of the circuit board 300. As discussed, the contact 440 of each electrical terminal 400 may define a cross-sectional, hollow oval shape. For example, the contact 440 of each electrical terminal 400 may define an eye 442. The electrically conductive material that each electrical terminal 400 is manufactured from may be pliable such that the contact 440 of each electrical terminal 400 conforms to the shape of the respective orifice 310 of the circuit board 300. Placing the contact 440 of each electrical terminal 400 within the respective orifice 310 such that contact 440 is compressed within the respective orifice 310 of the circuit board 300 has various benefits. For example, this configuration may ensure that the contact 440 of each electrical terminal 400 makes contact 440 with the circuit board 300 and is therefore in electrical communication with the circuit board 300. Also, placing the contact 440 of each electrical terminal 400 within the respective orifice 310 such that contact 440 is compressed within the respective orifice 310 of the circuit board 300 may prevent movement of each electrical terminal 400 relative to the circuit board 300.

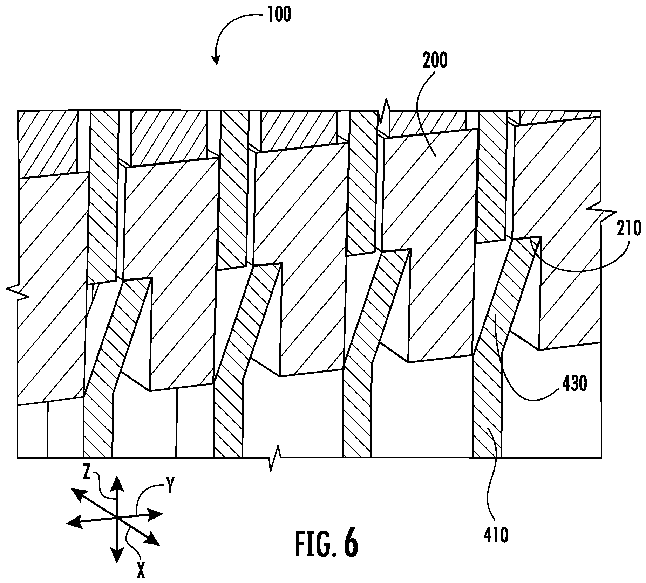

In various examples, the flag snap 430 of each electrical terminal 400 is positioned interior to the housing 200. For example, and with reference to FIG. 6, the flag snap 430 of each electrical terminal 400 may be positioned on an overhang 210 of the housing 200 when the flag snap 430 is in the second position. The overhang 210 of the housing 200 may be a portion of an interior wall of the housing 200. Positioning the flag snap 430 of each electrical terminal 400 within the housing 200, such as on an overhang 210 of the housing 200, has various benefits. For example, when the flag snap 430 is in the second position, the electrical terminal 400 may be prevented from moving upward relative to the housing 200. When the flag snap 430 is in the first position (i.e., positioned on the same plane as the main body 410 of the electrical terminal 400), the electrical terminal 400 may be allowed to move upward relative to the housing 200. This may be beneficial because each electrical terminal 400 may be installed within the electronic device 100 and, subsequently, uninstalled from the electronic device 100 without damaging or destroying the electrical terminal 400. As such, the electrical terminal 400 may be reused after being installed within the electronic device 100.

In various examples, the at least one shoulder 420 of each electrical terminal 400 may be positioned exterior to the housing 200. For example, and with reference to FIG. 7, each shoulder 420 may be positioned on a seat 220 of the housing 200. The seat 220 of the housing 200 may be an exterior wall of the housing 200. Positioning each shoulder 420 exterior to the housing 200 has various benefits. For example, the interaction between each shoulder 420 and the housing 200 may prevent the electrical terminal 400 from moving inward relative to the housing 200.

Incorporating the electrical terminal 400 of the present disclosure into an electronic device 100 has various other benefits not previously discussed. For example, installing the electrical terminal 400 of the present disclosure into the electronic device 100 does not require an insert molding process. The insert molding process is a molding process where thermoplastic or thermoset materials (e.g., the thermoplastic or thermoset materials of a conventional housing of a conventional electronic device) are molded around another component, such as a conventional electrical terminal. The insert molding process often requires the assistance of an operator, which may expose them to fumes emitted by the insert molding process, which may cause health and safety concerns.

As another example, installing the electrical terminal 400 of the present disclosure into the electronic device 100 does not require a soldering process, which is a process often used to insert conventional terminals into conventional housings of electronic devices. The soldering process may emit fumes, which the operator may be exposed to, which may cause health and safety concerns.

Also, installing the electrical terminal 400 of the present disclosure into an electronic device 100 may reduce manufacturing times and/or costs because of the simplification of the manufacturing process. For example, the insert molding process and/or the soldering processes may be time consuming and/or require an operator with specialized skills or training to execute the process. Installing the electrical terminal 400 of the present disclosure into an electronic device 100 does not require specialized skills or training. As such, the process of the present disclosure may reduce the amount of time and/or costs associated with installing an electrical terminal into an electronic device as compared to conventional methods.

Additionally, installing the electrical terminal 400 of the present disclosure into an electronic device 100 may reduce the likelihood that the electrical terminal 400 becomes decoupled from the circuit board and/or the housing 200. For example, with conventional methods, such as insert molding and soldering processes, movement, such as vibrational movement, may cause a conventional electrical terminal to become decoupled from the circuit board and/or the housing because of the weak bond between the metallic electrical terminal and the plastic housing. The various features of the electrical terminal 400 of the present disclosure (e.g., the shoulder 420, the flag snap 430, and/or the contact 440) may prevent the movement of the electrical terminal 400 relative to the housing 200. For example, each shoulder 420 may prevent a downward movement of the electrical terminal 400 relative to the housing 200. Each flag snap 430, when in the second position, may prevent an upward movement of the electrical terminal 400 relative to the housing 200. Each contact 440, because the contact 440 may be compressed within a corresponding orifice 310 of the circuit board 300, may prevent vertical and/or transverse movement of the contact 440 relative to the circuit board 300.

### Conclusion

The above descriptions of various embodiments of the subject disclosure and corresponding figures and what is described in the Abstract, are described herein for illustrative purposes, and are not intended to be exhaustive or to limit the disclosed embodiments to the precise forms disclosed. It is to be understood that one of ordinary skill in the art may recognize that other embodiments having modifications, permutations, combinations, and additions can be implemented for performing the same, similar, alternative, or substitute functions of the disclosed subject matter, and are therefore considered within the scope of this disclosure. Therefore, the disclosed subject matter should not be limited to any single embodiment described herein, but rather should be construed in breadth and scope in accordance with the appended claims below. Moreover, although the foregoing descriptions and the associated drawings describe example embodiments in the context of certain example combinations of elements and/or functions, it should be appreciated that different combinations of elements and/or functions may be provided by alternative embodiments without departing from the scope of the appended claims. In this regard, for example, different combinations of elements and/or functions than those explicitly described above are also contemplated as may be set forth in some of the appended claims. Although specific terms are employed herein, they are used in a generic and descriptive sense only and not for purposes of limitation.

## Claims

1. An electronic device comprising:
a housing;
a circuit board positioned within the housing; and
at least one electrical terminal positioned at least partially within the circuit board, each electrical terminal comprising:
a main body that extends along a plane;
at least one shoulder extending away from the main body; and
a flag snap positioned downward from the at least one shoulder and within the housing.

2. The electronic device of claim 1, wherein the flag snap of each electrical terminal is configured to pivot relative to the main body.

3. The electronic device of claim 1, wherein the flag snap of each electrical terminal is configured to pivot from a first position to a second position relative to the main body, wherein:
when the flag snap is in the first position, the flag snap is positioned on the plane, and
when the flag snap is in the second position, the flag snap extends away from the plane.

4. The electronic device of claim 3, wherein when the flag snap of each electrical terminal is in the second position, the flag snap extends away from the plane and in an upward direction.

5. The electronic device of claim 3, wherein the flag snap of each electrical terminal is configured to pivot from the second position to the first position such that the electrical terminal may be uninstalled from the electronic device.

6. The electronic device of claim 1, wherein the flag snap of each electrical terminal is configured to pivot relative to the main body from a first position to a second position, wherein:
when the flag snap is in the first position, the flag snap is allowed to move upward relative to the housing, and
when the flag snap is in the second position, the flag snap is prevented from moving upward relative to the housing.

7. The electronic device of claim 6, wherein when the flag snap of each electrical terminal is in the second position, the flag snap is positioned on an overhang of the housing.

8. The electronic device of claim 1, wherein each of the at least one shoulder of each electrical terminal is positioned on a respective plane defined by a respective main body of the respective electrical terminal.

9. The electronic device of claim 1, wherein each of the at least one shoulder of each electrical terminal defines a surface that extends in a transverse direction.

10. The electronic device of claim 1, wherein the at least one shoulder of each electrical terminal is positioned on a respective seat of the housing.

11. The electronic device of claim 1, wherein each electrical terminal comprises an electrical contact extending downward from the main body.

12. The electronic device of claim 11, wherein the electrical contact of each electrical terminal is compressed within a respective orifice of the circuit board.

13. The electronic device of claim 12, wherein the electrical contact of each electrical terminal is positioned on a plane defined by a respective main body of the respective electrical terminal.

14. The electronic device of claim 12, wherein the electrical contact defines a hollow oval shape.

15. An electrical terminal comprising:
a main body that extends along a plane;
at least one shoulder extending away from the main body; and
a flag snap positioned downward from the at least one shoulder. includes a housing and a circuit board positioned within the housing.
